# EUROPEAN PATENT APPLICATION

(11) **EP 3 185 309 A1**
(43) Date of publication of application: **28.06.2017**
(21) Application number: 15003665.5
(22) Date of filing: 23.12.2015
(51) Int. Cl.: H01L 31/048, B32B 17/10, B32B 7/12, C03C 17/36

(54) **HEAT REFLECTIVE SOLAR MODULE**

(71) Applicant: Amcor Flexibles Transpac, 3545 Halen (BE)
(72) Inventor: BÖGELS, Erik, 9000 Gent (BE); CHRISTOPHERSON, Roy, SN6 8EY Swindon (GB); ETTRIDGE, Peter, WR3 8DA Worcester, Worcestershire (GB); LOHWASSER, Wolfgang, 78262 Gailingen (DE)
(74) Representative: Althaus, Roland

(57) **Abstract**

The present invention relates to a solar module in the form of a laminate which exhibits a solar cell system having an encapsulation layer on a back side and a front side, a barrier layer arranged on the back side encapsulation layer and arranged on the front side encapsulation layer, a first SiOₓ layer, a base web layer, a second SiOₓ layer, an optional lacquer layer, an adhesive layer and a glass layer whereby a silver containing low-E coating is arranged within one or between two front side layers thereby protecting the corrosion sensitive silver containing low-E coating from exposure to moisture.

## Description

This invention relates to solar modules in the form of a laminate comprising a heat reflective coating.

Solar modules are widely used for generating electricity from sunlight. The electricity is generated by the solar cell system whereby a preferred material for solar cell systems is silicon as employed in crystalline or amorphous silicon solar modules. Another type of material used in so called CIGS-solar modules is a composition of copper, indium, gallium, sulfur and selenium. The abbreviation CIGS refers to the elements used. The CIGS type material allows the production of thin film solar modules. A common disadvantage of solar modules known in the state of the art is that their efficiency in electricity generation significantly deteriorates as their temperature rises due to light absorption in the infra-red spectrum. In regions having a high sunshine incidence the surface temperature of solar modules can exceed a temperature of 60° Celsius which seriously compromises the electricity production of solar modules in such regions.

A possible way to minimize this disadvantage is to provide heat reflection means in the form of heat reflection films or glass coatings which are available for domestic and industrial glazing applications. A further possibility to achieve a heat reflection is the application of a thin semi transparent silver film combined with anti reflective coatings for the visible light range which shows good transparency to visible light but high reflectivity to infrared radiation (Low emissivity coating, further called low-E coating). The thickness of the silver layer in these types of coatings is in the range of 3-15nm. The silver layer has a reflectivity between 10-70% in the visible light range. This silver layer is enclosed in between of two optical layers or layer stacks acting as antireflective coatings for the visible light range, therefore reducing the reflection of the silver layer 10-70% reflection down to 1-10% whereas the high infrared reflection (>90%) of the silver film is not compromised. This is one of the most efficient ways to prevent heat absorption that is known today. However, metallic silver films are extremely susceptible to corrosion, e.g. caused by diffusion of water vapour into the solar module. In the progress of corrosion the silver layer inside the low-E coating loses its heat reflecting property and reduces transparency to visual light, and thus the efficiency of electricity generation deteriorates again.

The object of the present invention is to provide a solar module which avoids the shortcoming of reduced infrared reflexivity due to corrosion of a silver layer and thereby limiting the performance of electricity generation.

The object is achieved by a solar module according to the present invention as defined in claim 1. Further embodiments are subject to the dependent claims.

A solar module according to the present invention exhibits the form of laminate. An encapsulation layer is arranged on the back side and on the front side of a solar cell system. The encapsulation layer provides protects the solar cell system and provides a certain mechanical stability to the solar cell system which is important since silicon based solar cell systems can only carry a very limited mechanical load as well as thin film type solar cell systems such CIGS solar cell systems can. On the back side encapsulation layer there is a barrier layer arranged. The barrier layer provides further mechanical stability and seals the back side of the solar module with respect to the environment. On the front side encapsulation layer of the solar cell system there are further layers arranged. These layers are a first SiOₓ layer, a base web layer, a second SiOₓ layer, a optional lacquer layer, an adhesive layer, a glass layer and a silver containing low-E coating which is arranged either within one of the layers on the front side or between two of the layers arranged on the front side of the solar cell system.

The laminate structure of the solar module includes a highly heat reflective layer in the form of a silver containing low-E coating. Such silver containing low-E coating advantageously provides for an efficient heat reflection. However, since silver is very susceptible to corrosion when it comes into contact with moisture, the silver containing low-E coating has to be protected from exposure to moisture. The arrangement of the silver containing low-E coating within one of the layers of the front side or between either two of the front side layers of the solar module advantageously achieves a minimization of the exposure of the silver containing low-E coating to moisture. Therefore the corrosion of the silver containing low-E coating is advantageously delayed or even prevented. This in turn allows efficient, stable and optimized electricity generation from the photovoltaic system.

The first SiOₓ layer (1.3<x<1.9) contacts the front side encapsulation layer on one side and the base web layer on its opposite side.

The base web layer is commonly made of perfluorinated tensides (PFT) such as perfluorinated alkyl sulphonates (PFAS), e.g. perfluoro octane sulphonate (PFOS), and perfluorinated carboxylic acids (PFCA), e.g. perfluoro octanoic acid (PFOA). On the base web layer there is arranged the second SiOₓ layer (1.3<x<1.9). On the second SiOₓ layer the optional lacquer layer is arranged. On top of the lacquer layer there is the adhesive layer arranged that contacts the glass layer which seals the front side of the solar module to the environment. The silver containing low-E coating has to be arranged either within one of the front side layers or between two of them in order to minimize its exposure to moisture.

The encapsulation layer may comprise cross-linkable materials such as ethylene vinyl acetate (EVA), polyolefin elastomer (POE), polyvinylbutyral (PVB) and epoxy resins. These materials are employed to encapsulate the solar cell system within the construction of a solar module and provide mechanical and environmental stability and also electrical insulation.

The lacquer layer may comprise silicon oxide based hybrid polymers, e.g. available as Ormocer^{®}. The adhesive layer comprises a polyurethane based adhesive.

In a preferred embodiment of the solar module according to the present invention the silver containing low-E coating is arranged between the glass layer and the adhesive layer. Thereby the silver containing low-E coating is protected from contact with water vapour that may diffuse into the solar module from its edges.

In a further preferred embodiment the silver containing low-E coating is alternatively arranged between the base web layer and the SiOₓ layer. Preferably the silver containing low-E coating is arranged between the base web layer and the second SiOₓ layer.

In another embodiment the silver containing low-E coating is arranged within the front side encapsulation layer of the solar cell system. The encapsulation materials that are applied to the solar cell system are generally cross-linkable polymers, e.g. ethylene vinyl acetate (EVA), polyolefin elastomer (POE), polyvinylbutyral (PVB), epoxy resins, or silicones are applied as a sheet or as a liquid adhesive in the fabrication process of a solar module. Thus, the heat reflective film in the form of a silver containing low-E coating may be applied within the encapsulation layer by extrusion coating. This may also be considered as silver containing low-E coating that is arranged between two thinner encapsulation layers compared to a single encapsulation layer.

In a preferred embodiment the adhesive layer comprises a water scavenging adhesive. Preferred water scavenging adhesive are polyurethane based adhesives.

The encapsulation layer of the solar cell system typically comprises cross-linkable polymers. Preferred are polymers selected from the group consisting of ethylene vinyl acetate (EVA), polyolefin elastomer (POE), polyvinylbutyral (PVB) and epoxy resins.

The encapsulation layer may further comprise a desiccant. Such a desiccant additionally reduces water vapour residues that may remain in the solar module after its fabrication. The desiccant comprised in the encapsulation layer also scavenges water vapour that diffuses into the solar module, e.g. through the edges of the module and thus advantageously minimizes water vapour and subsequent corrosion of the silver containing low-E coating within the solar module. Commonly used desiccants are CaCl, CaO, K₂CO₃, CuSO₄, Na₂SO₄ and KOH. CaO is a preferred desiccant.

In another embodiment the barrier layer comprises an aluminum foil preferably having a thickness greater than 20 microns and less than 150 microns. The aluminum foil in the barrier layer prevents the diffusion of water vapour through the barrier layer. In addition, it also reflects infrared radiation from the back side of the solar module and improves the efficiency of the electricity generation that otherwise would deteriorate when the solar module heats up

In a further embodiment barrier layer comprises a film containing ethylene vinyl acetate (EVA) and a desiccant whereby the film contacts the back side encapsulation layer.

In a preferred embodiment a moisture- or a water vapour-scavenging tape, e.g. comprising CaO as a desiccant, is arranged on an edge of the solar module. Preferably the water vapour-scavenging tape is arranged on all edges of the solar module. This efficiently prevents moisture ingress or the diffusion of water vapour through the edge interfaces of the solar module.

In a further preferred embodiment the solar module is enclosed by a frame which comprises a desiccant. Such desiccant is arranged between the solar module and the frame, e.g. in cavities formed by the frame and the solar module. This further minimizes the ingress of moisture or water vapour and therefore protects the silver containing low-E coating from corrosion.

The solar module according to the present invention is explained in more detail below with reference to exemplary embodiments in the drawings, in which, purely schematically:
- Fig. 1: shows a first embodiment of the solar module in longitudinal section;
- Fig 2: shows a second embodiment of the solar module in longitudinal section;
- Fig. 3: shows a third embodiment of the solar module in longitudinal section;
- Fig. 4: shows a further embodiment of the solar module with a circumferential frame in longitudinal section.

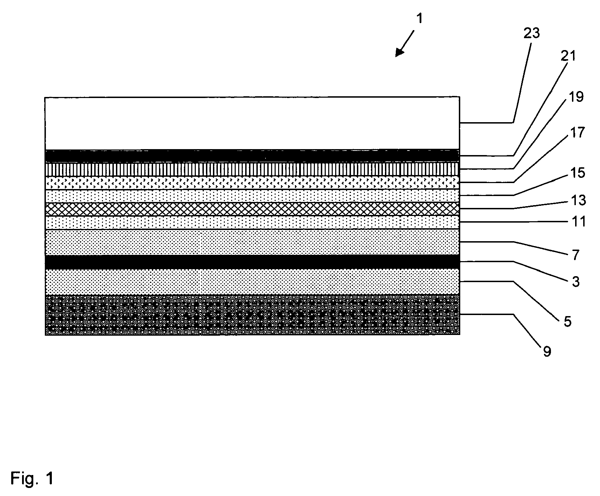

Fig. 1 shows a solar module 1 according to the present invention. It is easily perceived that the solar module 1 has a laminate structure. The solar cell system 3 has an encapsulation layer 5 arranged on its back side and an encapsulation layer 7 arranged on its front side, respectively. In order to further protect the solar cell system 3 a barrier layer 9 which contacts the encapsulation layer 5 is arranged on the back side of the solar cell system 3. On the front side of the solar cell system 3 there are a first SiOₓ layer 11 and a second SiOₓ layer 15, with a base web layer 13 placed in between the SiOₓ layers 11 and 15, arranged on the encapsulation layer 7. The second SiOₓ layer 15 is covered by lacquer layer 17 which in turn contacts an adhesive layer 19. In between the adhesive layer 19 and the glass layer 23 a silver containing low-E coating 21 is arranged. The glass layer 23 completes the front side of the solar cell system 3.

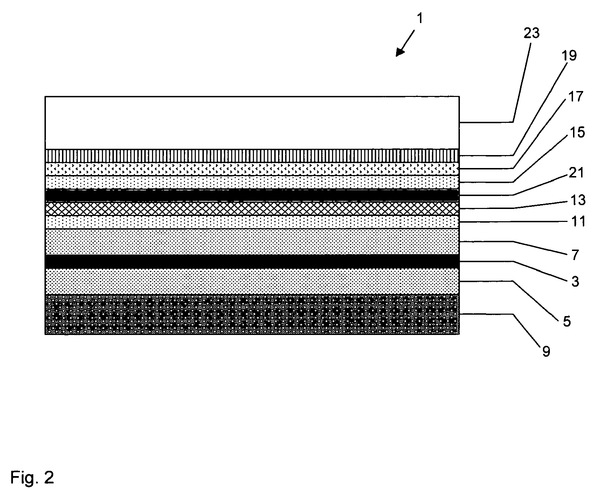

Fig. 2 shows a further embodiment of a solar module 1 according to the present invention. In this embodiment the silver containing low-E coating 21 is arranged in between the base web layer 13 and the second SiOₓ layer 15.

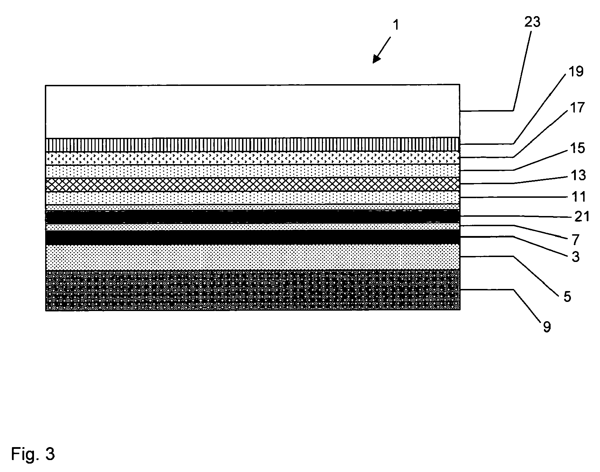

Fig. 3 shows a third embodiment of a solar module 1 according to the present invention. The silver containing low-E coating 21 is arranged within the encapsulation layer 7 on the front side of the solar cell system 3.

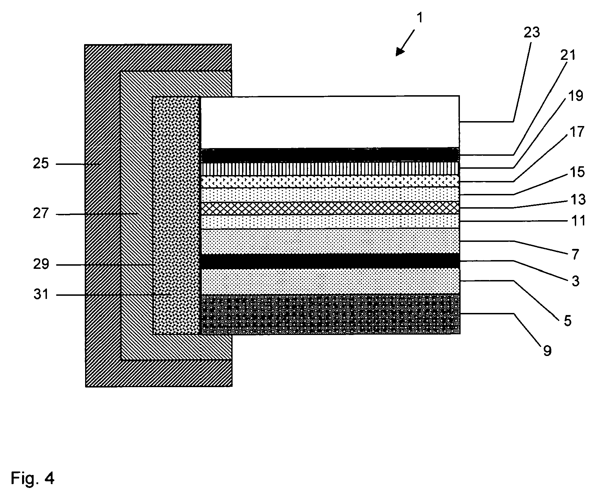

Fig. 4 shows a solar module having the same laminate structure as described in fig. 1. In addition, a frame 25 is shown protecting the edges of the solar module 1. The frame 25 is sealed to the solar module 1 by an adhesive film 27. A closed cavity 29 which runs around the entire solar module one contains a desiccant 31.

## Claims

1. Solar module (1) in the form of a laminate which exhibits a solar cell system system (3) having an encapsulation layer (5) on a back side and a encapsulation layer (7) on a front side of the solar cell system (3), a barrier layer (9) arranged on the back side encapsulation layer (5), and, arranged on the front side encapsulation layer (7), a first SiOₓ layer (11), a base web layer (13), a second SiOₓ layer (15), an optional lacquer layer (17), an adhesive layer (19) and a glass layer (23) whereby a silver containing low-E coating (21) is arranged within one or between two front side layers of the solar cell system (3).

2. Solar module according to claim 1 wherein the silver containing low-E coating (21) is arranged between the glass layer (23) and the adhesive layer (19).

3. Solar module according to claim 1 wherein the silver containing low-E coating (21) is arranged between the SiOₓ layer (15) and the base web layer (13).

4. Solar module according to claim 1 wherein the silver (21) layer is arranged within the front side encapsulation layer (7).

5. Solar module according to one of claims 1 - 4 wherein the adhesive layer (19) comprises a water scavenging adhesive.

6. Solar module according to claim 5 wherein the water scavenging adhesive is a polyurethane based adhesive.

7. Solar module according to one of claims 1 - 6 wherein the encapsulation layer (5, 7) comprises an encapsulation material selected from the group consisting of ethylene vinyl acetate (EVA), polyolefin elastomer (POE), polyvinylbutyral (PVB) and epoxy resins.

8. Solar module according to one of claims 1 - 7 wherein the encapsulation layer (5, 7) comprises a desiccant.

9. Solar module according to one of claims 1 - 8 wherein the barrier layer (9) comprises an aluminum foil preferably having a thickness of greater than 20 microns and less than 150 microns.

10. Solar module according to one of claims 1 - 9 wherein the barrier layer (9) comprises a film containing ethylene vinyl acetate and a desiccant whereby the film contacts the back side encapsulation layer (5).

11. Solar module according to one of claims 1 - 10 wherein a water scavenging edge tape is arranged on an edge of the solar module (1).

12. Solar module according to one of claims 1 - 11 wherein the solar module (1) is enclosed by a frame (25) further comprising a desiccant (31) whereby the desiccant is arranged between the solar module and the frame.
